# EUROPÄISCHE PATENTSCHRIFT

(11) **EP 3 788 449 B1**
(45) Veröffentlichungstag und Bekanntmachung des Hinweises auf die Patenterteilung: **23.11.2022**
(21) Anmeldenummer: 19717853.6
(22) Anmeldetag: 11.04.2019
(51) Int. Cl.: G05B 19/042, H03M 7/30

(54) **VERFAHREN ZUM REDUZIEREN EINER ZU ÜBERTRAGENDEN DATENMENGE EINES FELDGERÄTS**
METHOD FOR REDUCING A VOLUME OF DATA TO BE TRANSMITTED FROM A FIELD DEVICE
PROCÉDÉ POUR LA RÉDUCTION D'UNE QUANTITÉ DE DONNÉES À TRANSMETTRE D'UN APPAREIL DE TERRAIN

(30) Priorität: 03.05.2018 DE 102018110552
(43) Veröffentlichungstag der Anmeldung: 10.03.2021
(73) Patentinhaber: Endress+Hauser Process Solutions AG, 4153 Reinach (CH)
(72) Erfinder: WOHLGEMUTH, Markus, 4228 Erschwil (CH)
(74) Vertreter: Trenkle, Dennis
(86) Internationale Anmeldenummer: PCT/EP2019/059257
(87) Internationale Veröffentlichungsnummer: WO 2019/211075

(56) Entgegenhaltungen:
- US-A1- 2014 180 140
- US-B2- 9 071 257
- MISKOWICZ M: "Efficiency of level-crossing sampling for bandlimited gaussian random processes", FACTORY COMMUNICATION SYSTEMS, 2006 IEEE INTERNATIONAL WORKSHOP ON JUNE 27, 2006, PISCATAWAY, NJ, USA,IEEE, PISCATAWAY, NJ, USA, 1. Januar 2006 (2006-01-01), Seiten 137-142, XP031741886, ISBN: 978-1-4244-0379-0
- RIEGER R ET AL: "A Signal Based Clocking Scheme for A/D Converters in Body Sensor Networks", TENCON 2006. 2006 IEEE REGION 10 CONFERENCE, IEEE, PI, 14. November 2006 (2006-11-14), Seiten 1-4, XP031333192, ISBN: 978-1-4244-0548-0
- CHONG LIU ET AL: "An Energy-Efficient Data Collection Framework for Wireless Sensor Networks by Exploiting Spatiotemporal Correlation", IEEE TRANSACTIONS ON PARALLEL AND DISTRIBUTED SYSTEMS, IEEE SERVICE CENTER, LOS ALAMITOS, CA, US, Bd. 18, Nr. 7, 1. Juli 2007 (2007-07-01), Seiten 1010-1023, XP011185037, ISSN: 1045-9219, DOI: 10.1109/TPDS.2007.1046

## Beschreibung

Die Erfindung betrifft ein Verfahren zum Reduzieren einer zu übertragenden Datenmenge eines Feldgeräts.

Aus dem Stand der Technik sind bereits Feldgeräte bekannt geworden, die in industriellen Anlagen zum Einsatz kommen. In der Automatisierungstechnik ebenso wie in der Fertigungsautomatisierung werden vielfach Feldgeräte eingesetzt. Als Feldgeräte werden im Prinzip alle Geräte bezeichnet, die prozessnah eingesetzt werden und die prozessrelevante Informationen liefern oder verarbeiten. So werden Feldgeräte zur Erfassung und/oder Beeinflussung von Prozessgrößen verwendet. Zur Erfassung von Prozessgrößen dienen Sensoreinheiten. Diese werden beispielsweise zur Druck- und Temperaturmessung, Leitfähigkeitsmessung, Durchflussmessung, pH-Messung, Füllstandmessung, etc. verwendet und erfassen die entsprechenden Prozessvariablen Druck, Temperatur, Leitfähigkeit, pH-Wert, Füllstand, Durchfluss etc. Zur Beeinflussung von Prozessgrößen werden Aktorsysteme verwendet. Diese sind beispielsweise Pumpen oder Ventile, die den Durchfluss einer Flüssigkeit in einem Rohr oder den Füllstand in einem Behälter beeinflussen können. Neben den zuvor genannten Messgeräten und Aktoren werden unter Feldgeräten auch Remote I/Os, Funkadapter bzw. allgemein Geräte verstanden, die auf der Feldebene angeordnet sind.

In modernen Industrieanlagen sind Feldgeräte in der Regel über Kommunikationsnetzwerke wie beispielsweise Feldbusse (Profibus^{®}, Foundation^{®} Fieldbus, HART^{®}, etc.) mit übergeordneten Einheiten verbunden. Bei den übergeordneten Einheiten handelt es sich um Steuereinheiten, wie beispielsweise eine SPS (speicherprogrammierbare Steuerung), einem PLS (Prozessleitsystem) oder Cloud (Datenbank, welche über das Internet kontaktierbar ist). Die übergeordneten Einheiten dienen unter anderem zur Prozesssteuerung, Datenspeicherung und Datenauswertung, sowie zur Inbetriebnahme der Feldgeräte. Die von den Feldgeräten, insbesondere von den Sensoreinheiten, erfassten Messwerte werden über das jeweilige Bussystem an eine (oder gegebenenfalls mehrere) übergeordnete Einheit(en) übermittelt, die die Messwerte gegebenenfalls weiterverarbeiten und an den Leitstand oder weitere Systeme der Anlage weiterleiten. Der Leitstand und die weiteren Systeme dienen zur Prozessvisualisierung, Prozessüberwachung, Prozessoptimierung, Wartung, Datenanalyse und Prozessteuerung über die übergeordneten Einheiten. Daneben ist auch eine Datenübertragung von der übergeordneten Einheit über das Bussystem an die Feldgeräte erforderlich, insbesondere zur Konfiguration und Parametrierung von Feldgeräten sowie zur Ansteuerung von Aktoren.

In der Prozessindustrie werden im Rahmen der Digitalisierung und mit dem Drang zu dem "Industrial Internet of Things" (IIoT) immer mehr Feldgeräte, bzw. deren Sensoren auch an beweglichen und schwer zugänglichen Orten benötigt. Die Daten dieser Feldgeräte werden daher oft drahtlos übertragen. Idealerweise werden solche Feldgeräte über autarke Energiequellen mit der zum Betrieb benötigten elektrischen Energie versorgt. Zur Stromversorgung werden endliche Energiequellen wie beispielsweise Batterien, oder zumindest kurzzeitig kontinuierliche Energiequellen wie Solarzellen oder das sogenannte "Energy-Harvesting" verwendet. Für einen autarken Betrieb eines Feldgerät ist die benötigte Energiemenge dessen Sensors und der Datenübertragung der erhobenen Prozesswerte entscheidend. Ein großes Ziel ist dabei die vom Feldgerät benötigte elektrische Energie zu minimieren.

Bei einer drahtlosen Datenübertragung (z.B. unter Verwendung des drahtlosen Industrieprotokolls Wireless-HART) hängt die benötigte elektrische Energie direkt von der Datenrate ab. Soll ein Wert einer Prozessvariablen jede Minute übertragen werden, benötigt dies bedeutend mehr Energie, als wenn der Wert der Prozessvariablen beispielsweise nur jede Stunde oder einmal pro Tag übertragen wird. Bei einer konstant kleinen Übertragungsrate (z.B. einmal pro Stunde) gehen aber in der Regel Informationen verloren, da nicht bekannt ist, wie sich die Prozessvariable zwischen den zwei Übertragungen (bzw. den beiden erhobenen Werten) verhalten hat. Dem Empfänger der übertragenen Daten fehlen diese Informationen, um den Verlauf der Prozessvariablen korrekt nachbilden zu können. Eine einfache lineare Interpolation der Datenpunkte ist bei einer kleinen Übertragungsrate ist hierfür gegebenenfalls nicht ausreichend.

Wird die Datenübertragungsrate konstant hoch eingestellt (beispielsweise auf eine Übertragung pro Minute), so benötigt man bei einem länger konstanten Prozesswert viel Energie um denselben Wert der Prozessvariablen gegebenenfalls immer wieder zu übertragen. Als Ausgleich ist eine Änderung der Prozessvariablen für den Empfänger der übertragenen Daten in einer guten Auflösung nachvollziehbar.

Wird die Datenübertragungsrate konstant tief eingestellt (beispielsweise auf eine Übertragung pro Stunde), so benötigt man bei einer länger konstanten Prozessvariablen wenig Energie um deren konstant bleibenden Wert zu übertragen. Im Gegensatz dazu ist eine Änderung des der Prozessvariablen für den Empfänger der übertragenen Daten in einer schlechteren Auflösung nachvollziehbar.

Speziell bei Prozessen bzw. bei Prozessvariablen, bei denen der Wert über längere Zeit konstant ist und sich dann wieder zeitweise relativ schnell ändert, ist eine konstante Datenübertragungsrate nachteilig.

Aus dem Stand der Technik sind Verfahren bekannt, mit welcher die von einem Feldgerät zu übertragende Datenmenge angepasst werden kann. Aus der DE 102 09 734 A1 ist es beispielsweise bekannt, Übertragungszeitpunkte festzulegen. Zu einem Übertragungszeitpunkt wird geprüft, ob der aktuell zum Übertragungszeitpunkt erhobene Wert einer Prozessvariablen von demjenigen Wert einer Prozessvariablen abweicht, welcher am vorherigen Übertragungszeitpunkt erhoben wurde. Nur wenn der aktuelle Wert der Prozessvariablen um einen vorbestimmten Wert von dem vorherigen Wert der Prozessvariablen abweicht, wird der aktuelle Wert der Prozessvariablen am Übertragungszeitpunkt übertragen. Ähnliche Lehren sind in "Efficiency of levelcrossing sampling for bandlimited gaussian random processes", Miskowicz, Factory Communication Systems, 2006 IEEE International Workshop on June 27, 2006 definiert.

Jedoch kann es selbst nach Anwendung dieses Verfahrens vorkommen, dass mehr Daten übertragen - und somit mehr Energie verbraucht wird - als es zum zuverlässigen Nachbilden einer Messkurve seitens des Empfängers der übertragenen Daten notwendig wäre.

Ausgehend von dieser Problematik liegt der Erfindung die Aufgabe zugrunde, ein Verfahren vorzustellen, welches es erlaubt, die Energiemenge für eine Datenübertragung von Werten einer Prozessvariablen mit einer variablen Übertragungsrate zu minimieren, ohne Informationen zum Verlauf der Werte der Prozessvariablen zu verlieren.

Die Aufgabe wird durch ein Verfahren zum Reduzieren einer zu übertragenden Datenmenge eines Feldgeräts gelöst, wobei das Feldgerät Werte von zumindest einer Prozessvariablen erfasst, wobei das Feldgerät mit einem Netzwerkteilnehmer über ein Kommunikationsnetzwert in Kommunikationsverbindung steht und dazu ausgestaltet ist, die erfassten Werte der Prozessvariablen an den Netzwerkteilnehmer zu übermitteln, wobei zu festgelegten Zeitpunkten, welche festgelegte Zeitpunkte insbesondere eine konstante Zeitdifferenz zueinander aufweisen, eine Überprüfung des aktuellen Werts der Prozessvariable erfolgt, wobei im Zuge der Überprüfung ein Wert der Prozessvariable an einem ersten Zeitpunkt, welcher erste Zeitpunkt dem Zeitpunkt der Überprüfung entspricht, mit dem Wert der Prozessvariable eines zweiten Zeitpunkts verglichen wird, wobei der zweite Zeitpunkt der zuvor liegende Zeitpunkt des ersten Zeitpunkts ist, und wobei der Wert der Prozessvariable des ersten Zeitpunkts nur dann übermittelt wird, wenn der Betrag der Differenz des Wertes der Prozessvariable des ersten Zeitpunkts zu dem Wert der Prozessvariable des zweiten Zeitpunkts größer gleich einem vorbestimmten ersten Betrag ist. Erfindungsgemäß wird der Wert der Prozessvariable des ersten Zeitpunkts nur dann übermittelt wird, wenn zusätzlich der Betrag der Differenz des Werts der Prozessvariable des ersten Zeitpunkts zu dem Wert der Prozessvariable des zweiten Zeitpunkts zumindest um einen vorbestimmten Faktor von einem Betrag einer Differenz des Werts der Prozessvariable des zweiten Zeitpunkts zu einem Wert der Prozessvariable eines dritten Zeitpunkts abweicht, welcher dritte Zeitpunkt der zuvor liegende Zeitpunkt des zweiten Zeitpunkts ist.

Der große Vorteil des erfindungsgemäßen Verfahrens besteht darin, dass die von einem Feldgerät zu übertragende Datenmenge weiter reduziert werden kann. Dadurch wird die Lebensdauer einer endlichen Energiequelle erhöht bzw. der Energiebedarf einer kontinuierlichen Energiequelle optimiert. Die zu übertragende Datenmenge kann gegenüber dem aus dem Stand der Technik bekannten Verfahren dahingehend weiter reduziert werden, indem eine Steigung eines Messwertanstiegs, bzw. Messwertabstiegs berechnet wird. Hierfür wird die Differenz zwischen zwei Werten der Prozessvariablen gebildet. Anschließend wird der aktuelle Wert der Prozessvariablen am nachfolgenden Zeitpunkt erhoben und die Steigung zu dem Wert der Prozessvariablen am davorliegenden Zeitpunkt berechnet. Sind diese beiden Steigungen nahezu gleich, bzw. weichen diese um nicht mehr als einen vorbestimmten Wert voneinander ab, so wird der aktuelle Wert der Prozessvariablen nicht übertragen. An den nachfolgenden Zeitpunkten werden diese Verfahrensschritte wiederholt, bis die jeweiligen Steigungen um mehr als den vorbestimmten Wert voneinander abweichen und der aktuelle Wert der Prozessvariablen übertragen wird. Auf diese Weise besitzt der Empfänger der übertragenen Daten, also der übertragenen Werte der Prozessvariablen, diejenigen Informationen, welche er benötigt um den Verlauf der Prozessvariablen mit ausreichend hoher Genauigkeit nachbilden zu können. Auf diese Art und Weise ist eine maximale Information über den Verlauf der Prozessvariablen bei minimalem Energieverbrauch für die Datenübertragung möglich.

Bleibt der Wert der Prozessvariablen über einen definierten Zeitraum konstant, so kann vorgesehen sein, nach Ablauf dieses Zeitraums des aktuellen Wert der Prozessvariablen zum nächsten festgelegten Zeitpunkt zu übertragen. Auf diese Art und Weise kann ein Benutzer überprüfen, dass das Feldgerät nach wie vor funktionsfähig ist, bzw. die Energiequelle nicht erschöpft, beziehungsweise gestört ist.

Feldgeräte, welche im Zusammenhang mit dem erfindungsgemäßen Verfahren erwähnt werden, sind bereits im einleiten Teil der Beschreibung beispielhaft genannt worden.

Im Falle, dass der Betrag der Differenz des Wertes der Prozessvariablen des ersten Zeitpunkts zu dem Wert der Prozessvariablen des zweiten Zeitpunkts größer gleich einem vorbestimmten zweiten Betrag ist, wobei der zweite Betrag größer als der erste Betrag ist, wird zusätzlich der Wert der Prozessvariablen des zweiten Zeitpunkts übermittelt. Auf diese Weise kann der Verlauf der Prozessvariablen auch im Falle eines sprunghaften Anstiegs, bzw. einen sprunghaften Abstiegs der Prozessvariablen vom Empfänger der übertragenen Daten zuverlässig nachgebildet werden.

In einer bevorzugten Ausgestaltung des erfindungsgemäßen Verfahrens ist vorgesehen, dass die Werte der Prozessvariablen mit einem Zeitstempel versehen werden, wobei der Zeitstempel dem Zeitpunkt der Überprüfung entspricht.

Gemäß einer vorteilhaften Weiterbildung des erfindungsgemäßen Verfahrens ist vorgesehen, dass das Feldgerät die mit dem Zeitstempel versehenen Werte der Prozessvariablen als Historiendaten speichert und wobei das Feldgerät auf Basis der Historiendaten den ersten Betrag und/oder den zweiten Betrag und/oder den Faktor bestimmt. Basierend auf einem stetig wachsenden Erfahrungsschatz kann das Feldgerät die relevanten und für seine Applikation optimalen Werte selbstständig bestimmen, ohne dass ein Benutzer eine Eingabe tätigen muss. Für das Vergleichen der Historienwerte und das Bestimmen des ersten Betrags, des zweiten Betrags und/oder des Faktors wird beispielsweise ein KI(Künstliche Intelligenz)-Algorithmus, insbesondere basierend auf neuronalen Netzwerken, verwendet.

In einer bevorzugten Ausgestaltung des erfindungsgemäßen Verfahrens ist vorgesehen, dass als Kommunikationsnetzwerk ein Drahtlosnetzwerk verwendet wird, wobei die Werte der Prozessvariablen drahtlos von dem Feldgerät an den weiteren Netzwerkteilnehmer übermittelt werden.

Die Erfindung wird anhand der nachfolgenden Figuren näher erläutert. Es zeigen
Fig. 1: eine Anwendung eines Feldgeräts der Automatisierungstechnik, in welcher das erfindungsgemäße Verfahren Anwendung findet;
Fig. 2: eine erste Veranschaulichung des Grundproblems, welches von dem erfindungsgemäßen Verfahren gelöst wird;
Fig. 3: eine zweite Veranschaulichung des Grundproblems, welches von dem erfindungsgemäßen Verfahren gelöst wird;
Fig. 4: einen Lösungsansatz, wie dieser im Stand der Technik beschrieben ist;
Fig. 5: einen ersten erfindungsgemäßen Lösungsansatz;
Fig. 6: einen zweiten erfindungsgemäßen Lösungsansatz; und
Fig. 7: ein zusammenfassendes Ausführungsbeispiel des erfindungsgemäßen Verfahrens.

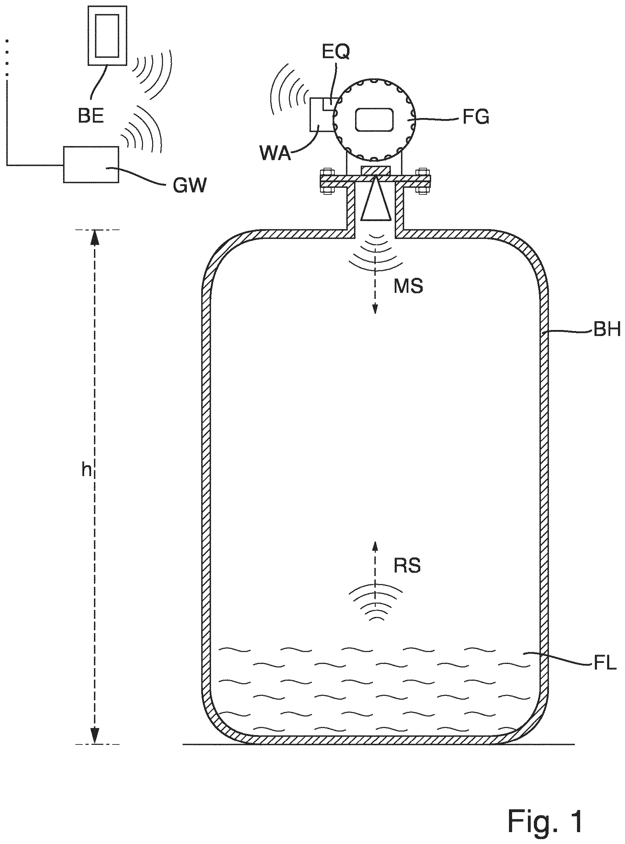

In Fig. 1 ist ein Behälter BH abgebildet, welcher in einer Anlage der

Prozessautomatisierung eingesetzt ist und an welchem ein Feldgerät FG angebracht ist. In dem Behälter ist ein Füllgut FL gelagert, bei welchem es sich in diesem Ausführungsbeispiel um Salz handelt. Es kann sich bei dem Füllgut FL aber alternativ um ein beliebiges fluidartiges Medium oder Schüttgut handeln. Zur Überwachung der Füllhöhe h des Füllgutes FL in dem Behälter BH wird ein Feldgerät FG in Form eines berührlosen Füllstandmessgerätes an dem Behälter BH angebracht. Die Füllhöhe h des Füllgutes FL wird dadurch gemessen, dass das Feldgerät ein Messsignal MS emittiert. Das Messsignal MS wird an der Oberfläche des Füllgutes FL reflektiert. Das reflektierte Signal RS wird von dem Feldgerät FG empfangen und bearbeitet. Anhand Kenngrößen des reflektierten Signals RS, beispielsweise anhand der Dauer zwischen dem Emittieren des Messsignals MS und dem Empfang des reflektierten Signals RS kann auf die Füllhöhe h des Füllgutes FL als Prozessvariable geschlossen werden. Das Feldgerät erhebt die aktuellen Werte der Prozessvariablen h in einer festgelegten Messrate.

Das Feldgerät besitzt eine autarke Energiequelle EQ, welche das Feldgerät FG mit seiner zum Betrieb notwendigen elektrischen Energie versorgt. Bei der Energiequelle EQ handelt es sich im vorliegenden Ausführungsbeispiel um eine Batterie. Es kann sich bei der Energiequelle EQ alternativ aber auch um eine kontinuierliche Energiequelle, wie beispielsweise eine Solarzelle, handeln.

Des Weiteren weist das Feldgerät FG einen Funkadapter WA auf. Der Funkadapter WA wird ebenfalls von der Energiequelle EQ mit seiner zum Betrieb notwendigen elektrischen Energie versorgt. Der Funkadapter ist dazu ausgestaltet, den aktuellsten vom Feldgerät FG erhobenen Wert der Prozessvariable h abzufragen und drahtlos zu übertragen. Hierbei wird insbesondere das Protokoll Wireless HART verwendet. Der übertragene Wert der Prozessvariablen h wird anschließend von einem weiteren Netzwerkteilnehmer empfangen. Bei dem weiteren Netzwerkteilnehmer handelt es sich beispielsweise um eine Bedieneinheit BE, welche den empfangenen Wert der Prozessvariablen h selbstständig verarbeitet, oder um ein Gateway GW, welches den empfangenen Wert der Prozessvariablen h weiterleitet, beispielsweise an die Leitstelle der Anlage. Allgemein ist davon auszugehen, dass der Betrieb des Funkadapters eine wesentlich höhere elektrische Energie benötigt, als zum Betreiben des Messbetriebs des Feldgeräts FG vonnöten ist. Die Übertragungsrate des Funkadapters WA (welche in allen Fällen kleiner als die Messrate des Feldgeräts FG ist) muss daher dermaßen gewählt werden, dass ein guter Kompromiss zwischen der Anzahl an übertragenen Daten pro Zeiteinheit und der dadurch benötigten Energiemenge erzielt ist.

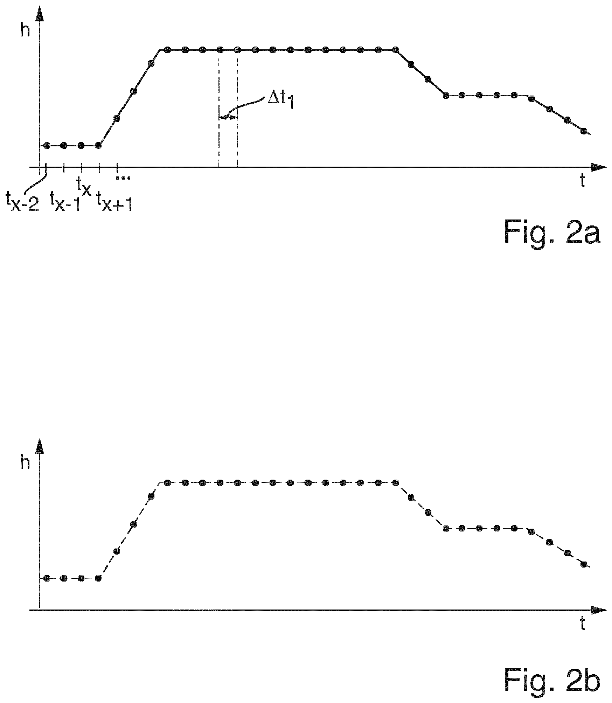

Fig. 2 veranschaulicht das Grundproblem, welches bei der Auswahl dieses Kompromisses vorliegt und welches dem erfindungsgemäßen Verfahren zugrunde liegt. Auf einer Zeitachse t, in Fig. 2a gezeigt, ist der Verlauf der Prozessvariablen h eingezeichnet. Zu festgelegten Zeitpunkten tₓ₋₁, tₓ, tₓ₊₁, tₓ₊₂, usw., welche jeweils um das feste Zeitintervall Δt₁ voneinander beabstandet liegen, fragt der Funkadapter den aktuellen Wert der Prozessvariablen h ab und überträgt diesen per Funk an den weiteren Netzwerkteilnehmer BE, GW. Das Zeitintervall Δt₁ ist in diesem Beispiel kurz gewählt und beträgt beispielsweise eine 1 Minute.

In Fig. 2b sind die vom Netzwerkteilnehmer BE, GW empfangenen Werte der Prozessvariablen h abgebildet. Durch stückweises lineares Interpolieren der einzelnen empfangenen Werte kann die Verlaufskurve der Prozessvariable zu einem hohen Grade zuverlässig nachgebildet werden. Die nachgebildete Verlaufskurve unterscheidet sich nur unwesentlich von der in Fig. 2a abgebildeten realen Verlaufskurve der Prozessvariablen h. Jedoch fällt aufgrund der häufigen Datenübertragung ein hoher Energiebedarf an, sodass die Energiequelle EQ das Feldgerät FG, bzw. den Funkadapter WA, unter Umständen nur für einen kurzen Zeitraum versorgen kann.

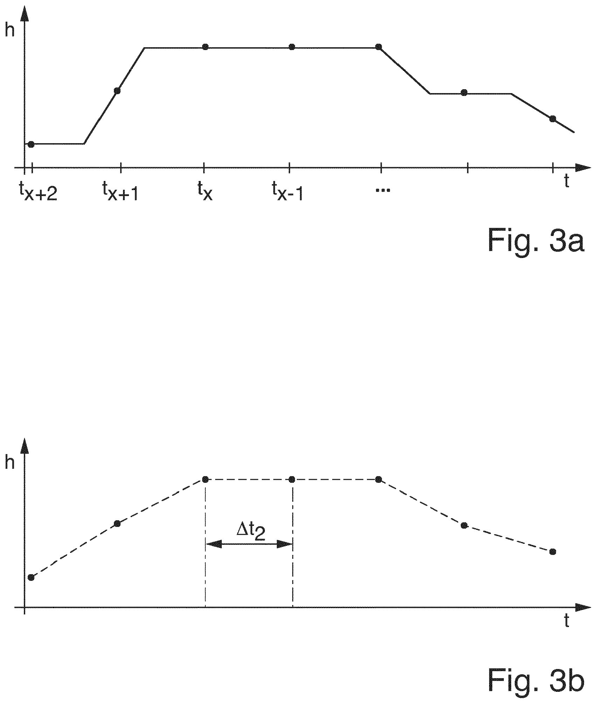

Fig. 3 zeigt einen weiteren Aspekt des Grundproblems. Auf einer Zeitachse t, in Fig. 2a gezeigt, ist der Verlauf der Prozessvariablen h eingezeichnet. Zu festgelegten Zeitpunkten tₓ₋₁, tₓ, tₓ₊₁, tₓ₊₂, usw., welche jeweils um das feste Zeitintervall Δt₁ voneinander beabstandet liegen, fragt der Funkadapter den aktuellen Wert der Prozessvariablen h ab und überträgt diesen per Funk an den weiteren Netzwerkteilnehmer BE, GW. Das Zeitintervall Δt₁ ist in diesem Beispiel lange gewählt und beträgt beispielsweise eine 1 Stunde.

In Fig. 3b sind die vom Netzwerkteilnehmer BE, GW empfangenen Werte der Prozessvariablen h abgebildet. Durch stückweises lineares Interpolieren der einzelnen empfangenen Werte kann die Verlaufskurve der Prozessvariable jedoch nur schlecht nachgebildet werden. Die nachgebildete Verlaufskurve unterscheidet sich sehr von der in Fig. 3a abgebildeten realen Verlaufskurve der Prozessvariablen h. Jedoch fällt aufgrund der weniger häufigen Datenübertragung ein niedrigerer Energiebedarf als in dem in Fig. 2 beschriebenen Beispiel an, sodass die Energiequelle EQ das Feldgerät FG, bzw. den Funkadapter WA, unter Umständen für einen längeren Zeitraum versorgen kann.

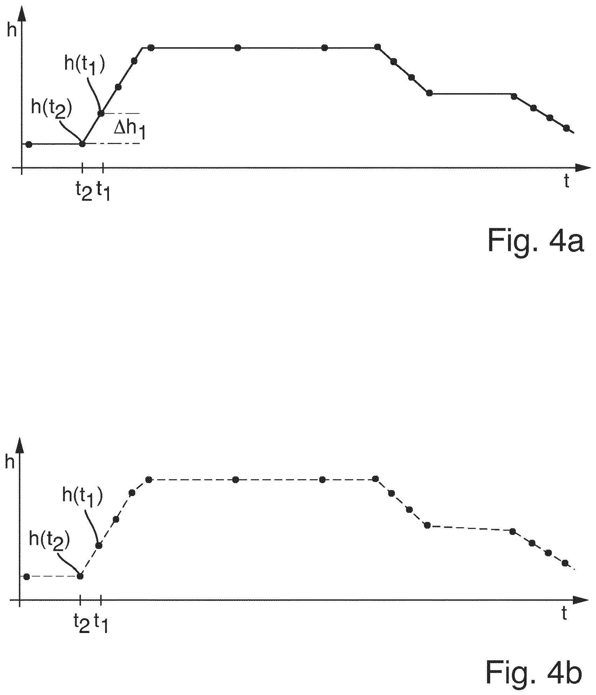

Fig. 4 zeigt einen Lösungsansatz, wie dieser im Stand der Technik, beispielsweise in der DE 102 09 734 A1 beschrieben ist. Fig. 4a zeigt hierbei die reale Messkurve des Prozessvariable h mit den Zeitpunkten, an welchen die Werte übertragen werten. Fig. 4b zeigt eine mittels Interpolation nachgebildete Messkurven aus den empfangenen Werten der Prozessvariable h.

Auch in diesem Beispiel werden die Werte der Prozessvariable h zu festgelegten Zeitpunkten abgerufen. Anschließend wird jedoch berechnet, ob eine Änderung der Werte der Prozessvariablen h zwischen zwei Zeitpunkten aufgetreten ist. Nur wenn diese Änderung größer gleich einem vorbestimmten Wert ist, wird der aktuelle Wert der Prozessvariablen h übertragen.

Beispielsweise wird der Wert h(t₁) zum Zeitpunkt t₁ erhoben. Anschließend wird der Betrag der Differenz h(t₁)-h(t₂) zu dem Wert h(t₂) gebildet. In diesem Fall ist dieser Betrag größer als ein festgelegter Betrag Δh₁, sodass der Wert h(t₁) übertragen wird.

Falls keine, oder eine unzureichend signifikante Änderung eintritt, wird ein Wert nicht übertragen. Somit kann Energie eingespart werden. Jedoch kann es selbst nach Anwendung dieses aus dem Stand der Technik bekannten Verfahrens vorkommen, dass mehr Werte übertragen - und somit mehr Energie verbraucht wird - als es zum zuverlässigen Nachbilden der Verlaufskurve der Prozessvariablen h seitens des Netzwerkteilnehmers BE, GW notwendig wäre. Auch können plötzliche Sprünge, sogenannte Spikes, der Prozessvariablen h nur unzureichend übertragen werden.

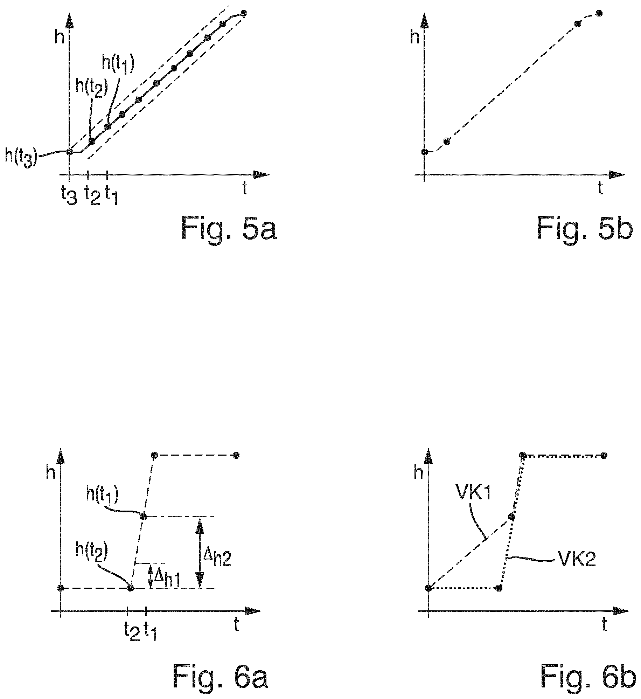

Fig. 5 zeigt einen ersten erfindungsgemäßen Lösungsansatz für dieses Problem.

Zusätzlich dazu, dass der Betrag der Differenz zwischen zwei Werten gebildet und mit einem festgelegten Betrag verglichen wird, wird ein Wert der Prozessvariablen h nur dann übertragen, wenn dieser Betrag der Differenz von dem Betrag der Differenz der beiden vorherigen Zeitpunkte zu einem vorbestimmten Faktor abweicht. In anderen Worten, erst wenn eine signifikante Änderung der Steigung auftritt, wird ein Wert der Prozessvariablen wieder übertragen. Im vorliegenden Anwendungsbeispiele kann Energie somit bei langsamen, kontinuierlichen Füllvorgängen des Behälters BH eingespart werden.

In Fig. 5a ist die reale Verlaufskurve der Prozessvariable h abgebildet. Der Messwert h(t₂) am Zeitpunkt t2 wird übertragen, da dieser um mehr als einen vorbestimmten Betrag von dem Messwert (ht₃) abweicht. Dieselbe Prüfung erfolgt zum Zeitpunkt t₁. Es wird der Betrag der Differenz h(t₁)-h(t₂) gebildet und mit dem Betrag der Differenz h(t₂)-h(t₃) verglichen. Im vorliegenden Fall unterscheiden sich diese Beträge, bzw. Steigungen kaum, daher wird der Wert h(t₁) nicht übertragen. Erst am Zeitpunkt tₓ liegt eine veränderte Steigung vor, so dass der Wert h(tₓ) übertragen wird.

Wie in Fig. 5b ersichtlich, kann die Verlaufskurve der Prozessvariablen h trotz Reduktion der übertragenen Werte gut durch stückweise lineare Interpolation nachgebildet werden.

Fig. 6 zeigt einen zweiten erfindungsgemäßen Lösungsansatz für dieses Problem, der auch mit dem ersten Lösungsansatz aus Fig. 5 kombiniert werden kann. Analog zu der in Fig. 4 beschrieben Vorgehensweise wird auch hier der Betrag der Differenz zwischen zwei Werten gebildet und mit einem festgelegten Betrag Δh₁ verglichen und ein Wert der Prozessvariable h abhängig von dieser Überprüfung übertragen. Überschreitet der Betrag der Differenz zusätzlich einen festgelegten Betrag Δh₂, wobei Δh₂ > Δh₁, so wird der Wert der Prozessvariable h vom vorherigen Zeitpunkt ebenfalls übertragen.

Als Beispiel hierfür ist in Fig. 6a ist die reale Verlaufskurve der Prozessvariable h abgebildet. Der Wert h(t₁) wird zum Zeitpunkt t₁ erhoben. Anschließend wird der Betrag der Differenz h(t₁)-h(t₂) zu dem Wert h(t₂) gebildet. In diesem Fall ist dieser Betrag größer als ein festgelegter Betrag Δh₁, sodass der Wert h(t₁) übertragen wird. Außerdem ist dieser Betrag größer als ein festgelegter Betrag Δh₂, sodass zusätzlich der Wert h(t₂) übertragen wird.

In Fig. 6b sind zwei nachgebildete Verlaufskurven VK1, VK2 der Prozessvariablen h abgebildet. Die erste Verlaufskurve VK1 wurde nach einer Übertragung der Werte der Prozessvariablen h nach dem bisher bekannten Verfahren (siehe Fig. 4) gebildet. Hierbei wurde der Wert h(t₂) nicht übertragen, so dass die Verlaufskurve VK1 den realen Verlauf der Prozessvariablen h nur unzureichend widerspiegelt. Die zweite Verlaufskurve wurde nach dem Übertragen der Werte der Prozessvariablen h nach dem zweiten erfindungsgemäßen Lösungsansatz gebildet. Da der Wert h(t₂) zusätzlich übertragen wurde, kann die Verlaufskurve VK2 den realen Verlauf der Prozessvariablen h ausreichend gut abbilden.

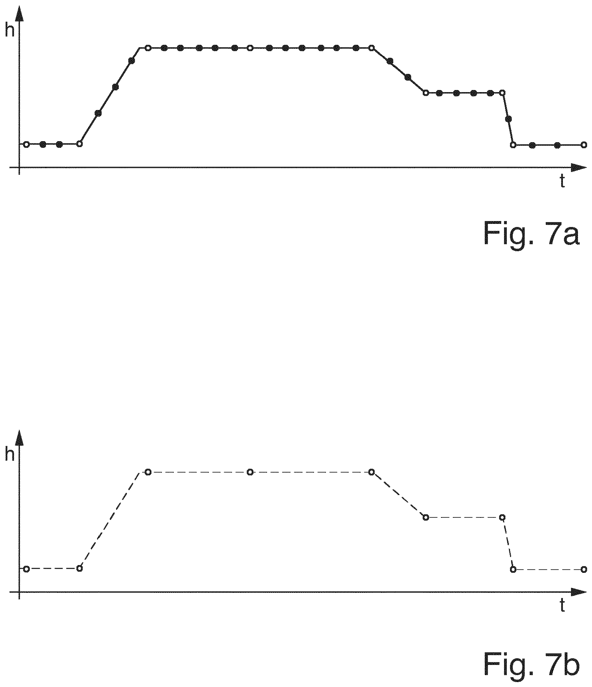

Fig. 7 zeigt eine Übertragung von Werten der Prozessvariablen h, welche eine Kombination der in Fig. 4 bis 6 beschriebenen Verfahren darstellt. Auf dieser Art und Weise kann die Datenübertragung auf ein absolutes Minimum reduziert werden, ohne dass wesentliche Informationen verloren gehen.

Fig. 7a zeigt einen realen Verlauf der Prozessvariablen h. Zu festgelegten Zeitpunkten, welche jeweils um das feste Zeitintervall Δt1 voneinander beabstandet liegen, fragt der Funkadapter WA den aktuellen Wert der Prozessvariablen h ab und führt die einzelnen Verfahrensschritte durch. Es werden nach Anwendung der Regeln jeweils nur diejenigen Werte der Prozessvariablen h übertragen, welche mit einem ungefüllten Kreis dargestellt sind. Die mit einem ausgefüllten Kreis dargestellten Werte der Prozessvariablen h werden nicht übertragen.

In Fig. 7b ist eine nachgebildete Verlaufskurve anhand der übertragenen Werte dargestellt. Diese entspricht der realen Verlaufskurve aus Fig. 7a nahezu vollständig.

Auch können beliebige andere Typen von Feldgeräten FG und mitnichten ausschließlich Füllstandmessgeräte verwendet werden.

Des Weiteren kann vorgesehen sein, dass das Feldgerät FG die erhobenen Werte mit einem Zeitstempel versieht und die mit dem Zeitstempel versehenen Werte der Prozessvariablen als Historiendaten speichert. Auf Basis der Historiendaten wird anschließend der erste Betrag Δh₁ (siehe Fig. 4) und/oder der zweite Betrag Δh₂ (siehe Fig. 6) und/oder der Faktor (siehe Fig. 5) bestimmt. Basierend auf einem stetig wachsenden Erfahrungsschatz kann das Feldgerät FG die relevanten und für seine Applikation optimalen Werte selbstständig bestimmen, ohne dass ein Benutzer eine Eingabe tätigen muss. Für das Vergleichen der Historienwerte und das Bestimmen des ersten Betrags, des zweiten Betrags und/oder des Faktors wird beispielsweise ein KI(Künstliche Intelligenz)-Algorithmus, insbesondere basierend auf neuronalen Netzwerken oder Deep Learning, verwendet.

### Bezugszeichenliste

- BE: Bedieneinheit, Netzwerkteilnehmer
- BH: Behälter
- EQ: Energiequelle
- FG: Feldgerät
- FL: Füllgut
- h: Prozessvariable (Füllhöhe)
- h(tₓ): Werte der Prozessvariablen an vorbestimmten Zeitpunkten
- GW: Gateway, Netzwerkteilnehmer
- MS: Messsignal
- RS: reflektiertes Signal
- tₓ: vorbestimmte Zeitpunkte
- VK1, VK2: Verlaufskurven
- WA: Funkadapter
- Δh₁: erster Betrag
- Δh₂: zweiter Betrag

## Patentansprüche

1. Verfahren zum Reduzieren einer zu übertragenden Datenmenge eines Feldgeräts (FG), wobei das Feldgerät (FG) Werte von zumindest einer Prozessvariablen (h) erfasst,
wobei das Feldgerät (FG) mit einem Netzwerkteilnehmer (BE, GW) über ein Kommunikationsnetzwerk in Kommunikationsverbindung steht und dazu ausgestaltet ist, die erfassten Werte der Prozessvariablen (h) an den Netzwerkteilnehmer (BE, GW) zu übermitteln,
wobei zu festgelegten Zeitpunkten (t), welche festgelegte Zeitpunkte (t) insbesondere eine konstante Zeitdifferenz zueinander aufweisen, eine Überprüfung des aktuellen Werts der Prozessvariable (h) erfolgt,
wobei im Zuge der Überprüfung ein Wert der Prozessvariable (h(t₁)) an einem ersten Zeitpunkt (t₁), welcher erste Zeitpunkt dem Zeitpunkt der Überprüfung entspricht, mit dem Wert der Prozessvariable (h(t₂)) eines zweiten Zeitpunkts (t₂) verglichen wird, wobei der zweite Zeitpunkt (t₂) der zuvor liegende Zeitpunkt des ersten Zeitpunkts (t₁) ist, und
wobei der Wert (h(t₁)) der Prozessvariable (h) des ersten Zeitpunkts (t₁) nur dann übermittelt wird, wenn der Betrag der Differenz des Wertes (h(t₁)) der Prozessvariable (h) des ersten Zeitpunkts (t₁) zu dem Wert (h(t₂)) der Prozessvariable (h) des zweiten Zeitpunkts (t₂) größer gleich einem vorbestimmten ersten Betrag (Δh₁) ist,
**dadurch gekennzeichnet, dass**
der Wert (h(t₁)) der Prozessvariable (h) des ersten Zeitpunkts (t₁) nur dann übermittelt wird, wenn zusätzlich der Betrag der Differenz des Werts (h(t₁)) der Prozessvariable (h) des ersten Zeitpunkts (t₁) zu dem Wert (h(t₂)) der Prozessvariable (h) des zweiten Zeitpunkts (t₂) zumindest um einen vorbestimmten Faktor von einem Betrag einer Differenz des Werts (h(t₂)) der Prozessvariable (h) des zweiten Zeitpunkts (t₂) zu einem Wert (h(t₃)) der Prozessvariable (h) eines dritten Zeitpunkts (t₃) abweicht, welcher dritte Zeitpunkt (t₃) der zuvor liegende Zeitpunkt des zweiten Zeitpunkts (t₂) ist,
wobei im Falle, dass der Betrag der Differenz des Wertes (h(t₁)) der Prozessvariablen (h) des ersten Zeitpunkts (t₁) zu dem Wert der Prozessvariablen (h) des zweiten Zeitpunkts (t₂) größer gleich einem vorbestimmten zweiten Betrag (Δh₂) ist, wobei der zweite Betrag (Δh₂) größer als der erste Betrag (Δh₁) ist, zusätzlich der Wert (h(t₂)) der Prozessvariablen (h) des zweiten Zeitpunkts (t₂) übermittelt wird.

2. Verfahren nach Anspruch 1, **dadurch gekennzeichnet, dass** die Werte (h(t₁), h(t₂), h(t₃)) der Prozessvariablen (h) mit einem Zeitstempel versehen werden, wobei der Zeitstempel dem Zeitpunkt (t₁, t₂, t₃) der jeweiligen Überprüfung entspricht.

3. Verfahren nach Anspruch 2, **dadurch gekennzeichnet, dass** das Feldgerät (FG) die mit dem Zeitstempel versehenen Werte (h(t₁), h(t₂), h(t₃)) der Prozessvariablen (h) als Historiendaten speichert und wobei das Feldgerät (FG) auf Basis der Historiendaten den ersten Betrag (Δh₁) und/oder den zweiten Betrag (Δh₂) und/oder den Faktor bestimmt.

4. Verfahren nach zumindest einem der vorherigen Ansprüche, **dadurch gekennzeichnet, dass** als Kommunikationsnetzwerk ein Drahtlosnetzwerk verwendet wird und wobei die Werte der Prozessvariablen (h) drahtlos von dem Feldgerät (FG) an den weiteren Netzwerkteilnehmer (BE, GW) übermittelt werden.

## Claims

1. Procedure to reduce a volume of data of a field device (FG) to be transmitted,
wherein the field device (FG) captures values of at least one process variable (h),
wherein the field device (FG) has a communication connection with a network participant (BE, GW) via a communication network and is designed to transmit the captured values of the process variables (h) to the network participant (BE, GW),
wherein the current value of the process variable (h) is checked at set times (t),
wherein said set times (t) particularly have a constant time difference in relation to one another,
wherein in the course of the verification, a value of the process variable (h(t₁)) at a first time (t₁) - said first time corresponding to the time of the verification - is compared to the value of the process variable (h(t₂)) of a second time (t₂), the second time (t₂) being the time before the first time (t₁), and
wherein the value (h(t₁)) of the process variable (h) of the first time (t₁) is only then transmitted if the value of the difference between the value (h(t₁)) of the process variable (h) of the first time (t₁) and the value (h(t₂)) of the process variable (h) of the second time (t₂) is greater or equal to a predefined first value (Δh₁),
**characterized in that**
the value (h(t₁)) of the process variable (h) of the first time (t₁) is only then transmitted if additionally the value of the difference between the value (h(t₁)) of the process variable (h) of the first time (t₁) and the value (h(t₂)) of the process variable (h) of the second time (t₂) deviates by at least a predetermined factor from a value of a difference between the value (h(t₂)) of the process variable (h) of the second time (t₂) and a value (h(t₃)) of the process variable (h) of a third time (t₃), - said third time (t₃) being the time before the second time (t₂) - wherein in the event that the value of the difference between the value (h(t₁)) of the process variable (h) of the first time (t₁) and the value of the process variable (h) of the second time (t₂) is greater than or equal to a predefined second value (Δh₂) - the second value (Δh₂) being greater than the first value (Δh₁) - the value (h(t₂)) of the process variable (h) of the second time (t₂) is also transmitted.

2. Procedure as claimed in Claim 1, **characterized in that** the values (h(t₁), h(t₂), h(t₃)) of the process variables (h) are given a timestamp, wherein the timestamp corresponds to the time (t₁, t₂, t₃) of the respective verification.

3. Procedure as claimed in Claim 2, **characterized in that** the field device (FG) saves the values (h(t₁), h(t₂), h(t₃)) of the process variables (h) assigned the timestamp as history data and wherein the field device (FG) determines the first value (Δₕ₁) and/or the second value (Δₕ₂) and/or the factor on the basis of the history data.

4. Procedure as claimed in at least one of the previous claims, **characterized in that** a wireless network is used as the communication network and
wherein the values of the process variables (h) are transmitted wirelessly from the field device (FG) to the other network participant (BE, GW).

## Revendications

1. Procédé destiné à la réduction d'une quantité de données à transmettre d'un appareil de terrain (FG), l'appareil de terrain (FG) saisissant des valeurs d'au moins une variable process (h),
l'appareil de terrain (FG) étant en liaison de communication avec un participant au réseau (BE, GW) par l'intermédiaire d'un réseau de communication et étant conçu pour transmettre les valeurs saisies des variables process (h) au participant au réseau (BE, GW),
une vérification de la valeur actuelle de la variable process (h) étant effectuée à des instants déterminés (t), lesquels instants déterminés (t) présentent notamment une différence de temps constante entre eux,
procédé pour lequel, au cours de la vérification, une valeur de la variable process (h(t₁)) à un premier instant (t₁), lequel premier instant correspond à l'instant de la vérification, est comparée à la valeur de la variable process (h(t₂)) d'un deuxième instant (t₂), le deuxième instant (t₂) étant l'instant précédent du premier instant (t₁), et
la valeur (h(t₁)) de la variable process (h) du premier instant (t₁) n'étant transmise que si la valeur absolue de la différence entre la valeur (h(t₁)) de la variable process (h) du premier instant (t₁) et la valeur (h(t₂)) de la variable process (h) du deuxième instant (t₂) est supérieure ou égale à une première valeur absolue (Δh₁) prédéterminée,
**caractérisé en ce que**
la valeur (h(t₁)) de la variable process (h) du premier instant (t₁) n'est transmise que lorsque si, en outre, le montant de la différence entre la valeur (h(t₁)) de la variable process (h) du premier instant (t₁) et la valeur (h(t₂)) de la variable process (h) du deuxième instant (t₂) s'écarte au moins d'un facteur prédéterminé par rapport à un montant d'une différence entre la valeur (h(t₂)) de la variable process (h) du deuxième instant (t₂) et une valeur (h(t₃)) de la variable process (h) d'un troisième instant (t₃), ce troisième instant (t₃) étant l'instant précédent du deuxième instant (t₂),
procédé pour lequel, dans le cas où la valeur de la différence entre la valeur (h(t₁)) de la variable process (h) du premier instant (t₁) et la valeur de la variable process (h) du deuxième instant (t₂) est supérieure ou égale à une deuxième valeur (Δh₂) prédéterminée - la deuxième valeur (Δh₂) étant supérieure à la première valeur (Δh₁) - on transmet en outre la valeur (h(t₂)) de la variable process (h) du deuxième instant (t₂).

2. Procédé selon la revendication 1, **caractérisé en ce que** les valeurs (h(t₁), h(t₂), h(t₃)) des variables process (h) sont munies d'un horodatage, l'horodatage correspondant à l'instant (t₁, t₂, t₃) de la vérification respective.

3. Procédé selon la revendication 2, **caractérisé en ce que** l'appareil de terrain (FG) enregistre les valeurs (h(t₁), h(t₂), h(t₃)) des variables process (h) munies de l'horodatage en tant que données d'historique et procédé pour lequel l'appareil de terrain (FG) détermine la première valeur (Δₕ₁) et/ou la deuxième valeur (Δₕ₂) et/ou le facteur sur la base des données d'historique.

4. Procédé selon au moins l'une des revendications précédentes, **caractérisé en ce qu'**un réseau sans fil est utilisé comme réseau de communication et
procédé pour lequel les valeurs des variables process (h) sont transmises sans fil de l'appareil de terrain (FG) à l'autre participant au réseau (BE, GW).
